Europäisches Patentamt

European Patent Office

Office européen des brevets

(19)

(11) Veröffentlichungsnummer: **0 213 555**

**A2**

(12) **EUROPÄISCHE PATENTANMELDUNG**

(21) Anmeldenummer: 86111555.8

(22) Anmeldetag: 21.08.86

(51) Int. Cl.⁴: **B29C 67/18** , B32B 31/20 , G03F 7/16 , H05K 3/00

(30) Priorität: 02.09.85 DE 3531271

(43) Veröffentlichungstag der Anmeldung:
11.03.87 Patentblatt 87/11

(84) Benannte Vertragsstaaten:
AT BE CH DE FR GB IT LI LU NL SE

(71) Anmelder: BASF Aktiengesellschaft
Carl-Bosch-Strasse 38
D-6700 Ludwigshafen(DE)

(72) Erfinder: Weiss, Gregor
Blockfeldstrasse 38
D-6704 Mutterstadt(DE)
Erfinder: Filsinger, Klaus
Orchideenweg 2
D-6835 Bruehl(DE)
Erfinder: Eckelmann, Rainer
Meisenweg 6
D-6733 Hassloch(DE)
Erfinder: Giese, Ronald
Heinestrasse 6
D-6711 Laumersheim(DE)
Erfinder: Koenig, Thomas
Dackenheimer Strasse 3
D-6700 Ludwigshafen(DE)
Erfinder: Eckle, Albrecht
Richard-Wagner-Strasse 42
D-6711 Beindersheim(DE)

(54) Vorrichtung zum Schneiden von Fotoresistbahnen in Fotoresistbogen definierter Grösse und exaktem, faltenfreiem Laminieren derselben auf flexiblen und starren Trägermaterialien.

(57) Vorrichtung zum Schneiden von Fotoresistbahnen in Fotoresistbogen definierter Größe und exaktem, faltenfreiem Laminieren der Fotoresitbogen auf flexiblen und starren Trägermaterialien, beispielsweise Leiterrohplatten, bestehend aus kupferkaschiertem Trägermaterial, wobei die Vorrichtung zum Schneiden und Laminieren in eine bewegliche Baugruppe eines Laminators integriert ist, so daß Schneiden und Laminieren ohne Unterbrechung des Laminiervorganges erfolgen.

## Vorrichtung zum Schneiden von Fotoresistbahnen in Fotoresistbogen definierter Größe und exaktem, faltenfreiem Laminieren derselben auf flexiblen und starren Trägermaterialien

Die Erfinding betrifft eine Vorrichtung zum Schneiden von Fotoresistbahnen in Fotoresistbogen definierter Größe und exaktem, faltenfreiem Laminieren der Fotoresistbogen auf flexiblen und starren Trägermaterialien, beispielsweise Leiterrohplatten, bestehend aus kupferkaschiertem Basismaterial.

Das Beschichten von Leiterrohplatten mit Fotoresist ist ein Teilprozeß des Verfahrens zur Herstellung von Leiterplatten.

Bekannt ist, einzelne Leiterrohplatten, bestehend aus Trägermaterial -meistens kupferkaschiertes Basismaterial -Platte um Platte zum Beschichten zwischen die im Laminator abgewickelten und durch die erhitzten Laminierwalzen zusammengepreßten Fotoresistbahnen einzuführen. Anschließend werden die beschichteten Leiterrohplatten am Auslauf aus dem Laminator manuell mittels eines Skalpells vereinzelt, d.h. die beidseitig auf den Leiterrohplatten aufgebrachten Fotoresistbahnen, die als Endlosband aus dem Laminator kommen, werden durchgeschnitten, und die Randüberstände an der Leiterrohplatte werden beschnitten.

Diese Schnittart sowohl von Hand als auch maschinell hat den Nachteil, daß geringe Fotoresistüberstände von den Leiterrohplatten abplatzen und bei Fertigungsprozessen Fehlstellen verursachen.

Dieser Nachteil kann dadurch vermieden werden, daß der Fotoresist allseitig je ca. 10 mm kleiner geschnitten ist als die Leiterrohplatte, also ein umlaufender Streifen von ca. 10 mm kupferkaschiertem Basismaterial auf der Leiterrohplatte nicht von Fotoresist bedeckt ist. Gleichzeitig wird durch diese Schneidtechnik im Fertigungsfolgeprozeß der galvanischen Metallabscheidung die Gleichmäßigkeit der Abscheidung durch diesen freiliegenden umlaufenden Kupferstreifen, bekannt als sogenannter Galvano-Rahmen, verbessert.

Für diese Schneidtechnik werden heute mehrere Geräte angeboten, die jedoch entscheidende Nachteile aufweisen, beispielsweise Faltenbildung des Fotoresists und zweimaliges Anhalten des Laminarvorganges während der Fotoresistanhaftung und während der Schneidvorgänge.

Da die Übertragung des Fotoresistes idealerweise bei 110°C bei relativem Liniendruck von 150 kp bis 320 kp über die Gesamtwalzenbreite der Laminierwalzen von beispielsweise 746 mm durch Verflüssigung des Fotoresistes erfolgt, wird einsichtig, daß dieses Anhalten unter Hitze und Druck äußerst problematisch ist und einen außerordentlichen Aufwand erfordert, um die mögliche unerwünschte Folge wie Streifen-und Blasenbildung zu unterbinden. So wird Temperatur mit ca. 110°C über zwei Walzenpaare direkt auf die Leiterrohplatten übertragen, während die Laminierwalzen nur mehr mit 70-90°C beheizt sind. Diese Maßnahmen sind gegen den nachstehend beschriebenen Stand der Technik für die Fotoresistübertragung aufwendige Kompromisse auch in der Sicht der Laminierergebnisse. Beim Stand der Technik werden zwischen nur zwei, mit Siliconkautschuk beschichteten Stahlwalzen bei 110°C und relativem Liniendruck von 150 kp/cm bis 320 kp/cm über die Gesamtwalzenbreite der Laminierwalzen von beispielsweise 746 mm gleichzeitig beide Fotoresistbogen in einer fortlaufenden definierten Bewegung übertragen.

Der Erfindung liegt daher die Aufgabe zugrunde, das Formatschneiden der Fotoresistbahnen so zu bewerkstelligen, daß der eigentliche Laminiervorgang mit den idealen Laminierparametern des Standes der Technik ohne Unterbrechung, d.h. ohne aufwendige Kompromisse ideale Laminierergebnisse zu erzielen, und wobei die Fotoresistübertragung auf die Leiterrohplatte ohne Falten- und Blasenbildung erfolgt.

Diese Aufgabe wird erfindungsgemäß dadurch gelöst, daß die Vorrichtung zum Schneiden und Laminieren in eine bewegliche Baugruppe eines Laminators integriert ist, so daß Schneiden und Laminieren ohne Unterbrechung des Laminiervorgangs erfolgen.

Speziell für dünne Leiterrohplatten ist die erfindungsgemäße Vorrichtung vorteilhaft.

Dies bedeutet, daß für den Schneidevorgang der laufenden, abzuwickelnden Fotoresistbahnen die gesamte Vorrichtung mit den Schneidemessern durch mechanische Verbindung über Magnetkupplung mit dem Laminator gekoppelt und bewegt wird.

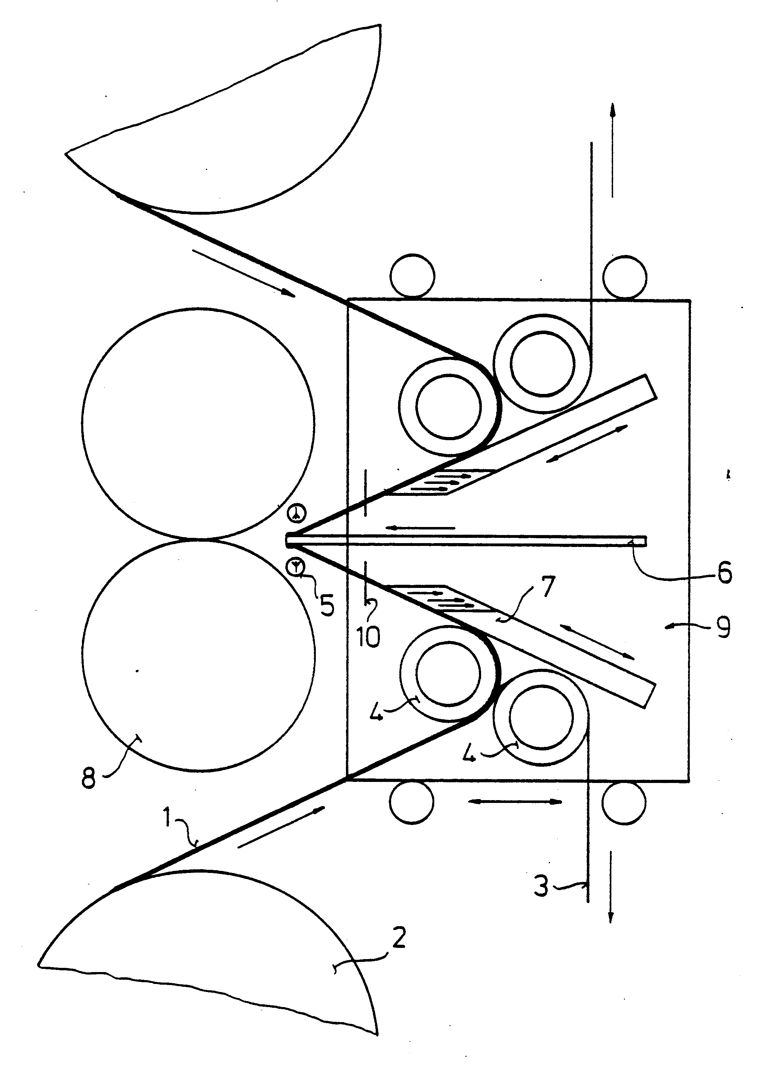

Ein Ausführungsbeispiel der Erfindung mit den wesentlichen erfinderischen Merkmalen ist in der Zeichnung dargestellt und wird im folgenden näher beschrieben. Die Zeichnung zeigt einen Schnitt durch die Vorrichtung und die Laminierwalzen des dazugehörenden Laminators.

Die Fotoresistbahnen 1 werden nach Abrollen von den beiden Fotoresistrollen 2 und nach Abziehen der Schutzfolien 3, die separat wieder aufgerollt werden, durch die während des Prozeßablaufes angetriebenen Transportwalzen 4 der erfindungsgemäßen Vorrichtung zugeführt. Die Transportwalzen sind mit einem Freilauf ausgestattet, so daß die manuelle Einführung der Fotorestbahnen, beispielsweise nach dem Einlegen neuer Fotoresistrollen problemos möglich ist. Beide Fotoresistbahnen werden bis zu einer definierten Position bei den sogenannten Blasrohren 5 geführt. Nach der Inbetriebnahme des Laminators werden die Leiterrohplatten 6 Platte um Platte mit einem vorgegebenen Abstand zwischen den einzelnen Platten zum Laminieren geführt. Gleichzeitig werden die Fotoresistbahnen in ihrer gesamten Breite an die Vorderkante der Vakuumleisten 7 mittels Unterdruck angesaugt. Die bis zu den Blasrohren überstehende Fotoresistbahnen werden in ihrer gesamten Breite mittels aus dem Blasrohr ausströmender Luft geführt. Beim Erreichen einer entsprechenden Position der ersten zugeführten Leiterrohplatte mittels einer nicht dargestellten Einschubvorrichtung werden die Transportwalzen angetrieben sowie die Vakuumleisten mit den an der Vorderkante derselben anhaftenden Fotoresistbahnen in Richtung auf die Laminierwalzen 8 zu bewegt, und zwar soweit, bis die Fotoresistbahnen gemeinsam mit der Leiterrohplatte durch die angetriebenen Laminerwalzen unter gleichzeitigem Vorschub der Fotoresistbahnen durch die Transportwalzen erfaßt werden und dadurch der Laminiervorgang beginnt. Gleichzeitig mit Erfassen der Fotoresistbahnen durch die Laminarwalzen werden die Vakuumleisten in die Ausgangsstellenug zurückgefahren. Bei entsprechender Position der hinteren (nachlaufenden) Leiterrohplattenkante wird die gesamte auf einer beweglichen Baugruppe 9 montierte Vorrichtung durch eine Magnetkupplung mechanisch mit dem Antrieb des Laminators verbunden und in Richtung auf die Laminarwalzen hin in Bewegung gesetzt. Gleichzeitig bewegen sich die beiden Schneidemesser 10, wobei ein Parallelschnitt an beiden Fotoresistbahnen erzielt wird, ohne daß während des Schneidevorganges ein Anhalten des Laminiervorganges notwendig wird. Bei jeder nachfolgenden Leiterrohplatte werden sodann die beschriebenen Vorgänge laufend und automatisch wiederholt. Die Steuerung aller Bewegungsvorgänge erfolgt optoelektronisch.

Die mit der erfindungsgemäßen Vorrichtung erzielten Vorteile bestehen insbesonder in der Möglichkeit des Einsatzes einer Laminiertechnik, ohne den Laminiervorgang unterbrechen zu müssen, bei vergleichsweise geringem Bauaufwand gegenüber bekannten Geräten. Des weiteren erreicht man beste Übertragungsergebnisse der Fotoresistbahnen auf speziell dünne Leiterrohplatten, d.h. auf Leiterrohplatten bis zu einer Stärke von nur 0,1 mm. Mittels der erfindungsgemäßen Vorrichtung wird also ein faltenfreies Übertragen der Fotoresistbahnen auf diese dünnen Leiterrohplatten möglich.

**Ansprüche**

1. Vorrichtung zum Schneiden von Fotoresistbahnen in Fotoresistbogen definierter Größe und exaktem, faltenfreiem Laminieren der Fotoresistbogen auf flexiblen und starren Trägermaterialien, beispielsweise Leiterrohplatten, bestehend aus kupferkaschiertem Basismaterial dadurch gekennzeichnet, daß die Vorrichtung zum schneiden und Laminieren in eine bewegliche Baugruppe eines Laminators integriert ist, so daß Schneiden und Laminieren ohne Unterbrechung des Laminiervorganges erfolgen.

2. Vorrichtung nach Anspruch 1, dadurch gekennzeichnet, daß mittels der Vorrichtung exaktes, faltenfreies Laminieren auf dünnen Trägermaterialien -beispielsweise nur 0,1 mm stark -möglich ist.